# EUROPEAN PATENT SPECIFICATION

(11) **EP 3 315 978 B1**
(45) Date of publication and mention of the grant of the patent: **15.06.2022**
(21) Application number: 17196470.3
(22) Date of filing: 13.10.2017
(51) Int. Cl.: G01R 15/18, G01R 15/20

(54) **CURRENT SENSOR**
STROMSENSOR
CAPTEUR DE COURANT

(30) Priority: 01.11.2016 JP 2016214590
(43) Date of publication of application: 02.05.2018
(73) Proprietor: DENSO CORPORATION, Aichi-pref 448-8661 (JP)
(72) Inventor: NAKAYAMA, Wataru, TOYOTA-SHI, AICHI-KEN, 471-8571 (JP)
(74) Representative: Cabinet Beau de Loménie

(56) References cited:
- JP-A- 2013 013 169
- US-A1- 2006 043 960
- US-A1- 2006 232 262

## Description

### BACKGROUND OF THE INVENTION

### 1. Field of the Invention

The present specification discloses a current sensor including a magnetism-collecting core and a magnetoelectric transducer.

### 2. Description of Related Art

There is known a current sensor including a magnetism-collecting core and a magnetoelectric transducer. The magnetism-collecting core is in the shape of a ring surrounding a conductor through which a current flows. The magnetism-collecting core has a gap formed by parting one place of the ring. The magnetoelectric transducer is built in a sensor chip, and the sensor chip is disposed in the gap of the magnetism-collecting core. The sensor chip is disposed such that a magnetic induction direction of the magnetoelectric transducer inside the sensor chip is along a normal direction of end faces of the magnetism-collecting core, facing the gap. The magnetism-collecting core collects a magnetic flux caused by a current flowing through the conductor. The magnetoelectric transducer measures a magnetic flux passing through the gap of the magnetism-collecting core. The sensor chip is connected to a sensor controller that determines the current flowing through the conductor based on a level of the magnetic flux measured by the magnetoelectric transducer.

Japanese Patent Application Publication No. 2013-013169 discloses a current sensor in which two sensor chips of the same type are disposed in a gap of a magnetism-collecting core. The sensor chips are aligned along an extending direction of a conductor. A sensor controller outputs an error signal indicating that anomaly occurs in any one of the sensor chips when an output difference between the two sensor chips of the same type (two magnetoelectric transducers) exceeds a predetermined threshold value (threshold value of error determination).

Documents US 2006/232262 and US 2006/043960 both disclose known current detection devices.

### SUMMARY OF THE INVENTION

When two sensor chips are disposed in a gap, the two sensor chips are disposed at corresponding bilaterally symmetric (or vertically symmetric) positions across an end face center of a magnetism-collecting core as viewed from the normal direction of end faces of the magnetism-collecting core, facing the gap. The two sensor chips each are disposed in the same posture. When the magnetism-collecting core has an end face with a sufficiently large area, the two sensor chips are exposed in a uniform magnetic field. When the two sensor chips are normal, the sensor chips each output the same measurement result.

Meanwhile, a magnetoelectric transducer may be housed at a position which deviates from the center of the sensor chip in any direction due to a requirement of a sensor chip in manufacture or design. For example, when two sensor chips disposed in the same posture at corresponding bilaterally symmetric positions across the center of an end face of a magnetism-collecting core are viewed from the normal direction of the end faces of the magnetism-collecting core, a magnetoelectric transducer is positioned rightward in the chips. At this time, a magnetoelectric transducer in the sensor chip on the left side across an end face center is positioned closer to the end face center than a magnetoelectric transducer in the sensor chip on the right side. That is, even if the sensor chips are disposed at corresponding symmetric positions across the end face center, each of the magnetoelectric transducers in two sensor chips is at a different distance from the end face center. There is an allowable case where a magnetism-collecting core has an end face with a large area, and the whole of two sensor chips is exposed in a uniform magnetic field. Unfortunately, when an area of an end face of a magnetism-collecting core is reduced to reduce a sensor in size, a uniform range of a magnetic field decreases in a gap. As a result, a slight difference in distance between each of two magnetoelectric transducers and the end face center of the magnetism-collecting core causes a difference in magnetic field applied to each of the two magnetoelectric transducers, thereby causing a difference in output (output of sensor chips) of the two magnetoelectric transducers. The invention of the present specification provides a technique for reducing a difference in output of two sensor chips caused by displacement of a magnetoelectric transducer in a sensor chip from the chip center.

The invention proposes a current sensor for measuring a current flowing through a conductor. The current sensor includes a magnetism-collecting core having a ring shape of a ring surrounding a conductor, the ring having a gap at a part of the ring shape; and two sensor chips housing respective magnetoelectric transducers, and the two sensor chips being disposed in the gap, the two sensor chips being disposed such that a magnetic induction direction of each of the two sensor chips is the same as a normal direction of end faces of the magnetism-collecting core, the end faces facing the gap, and the two sensor chips being disposed in a point symmetric manner to a center of the gap, as viewed from the normal direction. Each of the magnetoelectric transducers is positioned at a position equidistant from the center of the gap.

The invention also proposes a current sensor for measuring a current flowing through a conductor. The current sensor includes a magnetism-collecting core having a ring shape of a ring surrounding a conductor, the ring having a gap at a part of the ring one place to form a gap; and two sensor chips housing respective magnetoelectric transducers, and the two sensor chips being disposed in the gap, the two sensor chips being disposed such that a magnetic induction direction of each of the two sensor chips is the same as a normal direction of end faces of the magnetism-collecting core, the end faces facing the gap, and the two sensor chips being disposed in an axially symmetric manner to a straight line passing through a center of the gap. Each of the magnetoelectric transducers is positioned at a position equidistant from the center of the gap.

For example, it is assumed that two sensor chips are disposed across an end face center in an axially symmetric manner such that a right side face of each of the sensor chips is positioned near the end face center, a left side face thereof is positioned away from the end face center. Then, it is assumed that a magnetoelectric transducer is positioned rightward from the center in the sensor chips. In that case, according to the placement, each of magnetoelectric transducers of the two respective sensor chips is positioned closer to the end face center than to the center of each of the chips. Each of the magnetoelectric transducers of the two respective sensor chips is positioned at a position equidistant from the end face center, as viewed from the normal direction of the end faces. Thus, each of the two magnetoelectric transducers is exposed in an identical magnetic field, so that an output difference between the two magnetoelectric transducers (sensor chips) does not increase.

The expression "the two sensor chips being disposed in an axially symmetric manner to a straight line passing through the center of the gap" can be described in other words as follows. That is, the two sensor chips are disposed such that a perpendicular bisector of the sensor chip center passes through the end face center, and that posture of each of the two sensor chips is mirror symmetric to the perpendicular bisector, as viewed from the normal direction of the end faces.

It is preferable that the current sensor disclosed in the present specification may further include a sensor controller. The sensor controller may be configured to output an error signal (a signal indicating anomaly that occurs in at least one of the sensor chips) when an output difference between the two magnetoelectric transducers exceeds a predetermined threshold value. The current sensor described above has a small output difference between the two sensor chips in normal time, so that the predetermined threshold value can be reduced to improve accuracy of anomaly detection.

The two sensor chips may be disposed such that when the two sensor chips output positive values for a magnetic flux passing the gap respectively, a magnetic induction direction of one of the two sensor chips is opposite to the magnetic induction direction of the other one of the two sensor chips. In that case, outputs of the two respective sensor chips are opposite to each other for positive and negative values. Thus, only simply adding outputs of the two sensor chips together enables an output difference between the two sensor chips (difference in an absolute value of an output value) to be acquired. Then, the sensor controller has a simple circuit.

Details and modifications of the technique disclosed in the present specification will be described in the following "DETAILED DESCRIPTION OF EMBODIMENTS".

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a block diagram of an electric power system of an electric vehicle, using a current sensor of an example;
FIG. 2A is a front view of a current sensor unit;
FIG. 2B is a plan view of the current sensor unit;
FIG. 3A is an enlarged plan view of a periphery of a gap;
FIG. 3B illustrates a placement of sensor chips as viewed from a normal direction of end faces of a magnetism-collecting core;
FIG. 4 illustrates a relationship between a magnetic field and sensor chips in a gap;
FIG. 5 is a graph showing outputs of two sensor chips in accordance with strength of a magnetic field;
FIG. 6A is an enlarged plan view of a periphery of a gap;
FIG. 6B illustrates placement of the sensor chips as viewed from a normal direction of end faces of a magnetism-collecting core;
FIG. 7 illustrates yet another placement example of two sensor chips (an enlarged plan view of a periphery of a gap); and
FIG. 8 illustrates yet another placement example of two sensor chips (an illustration as viewed from a normal direction of end faces of a magnetism-collecting core).

### DETAILED DESCRIPTION OF EMBODIMENTS

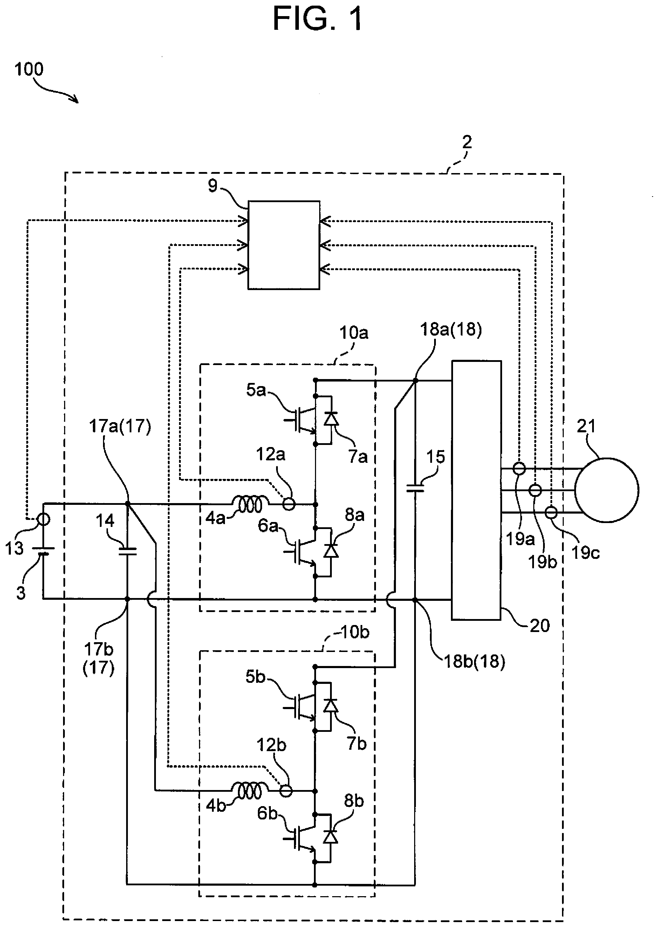

With reference to drawings, a current sensor of an example will be described. First, an electric vehicle using the current sensor of the example will be described. FIG. 1 is a block diagram of an electric power system of an electric vehicle 100. The electric vehicle 100 travels by driving a motor 21 with electric power of a battery 3. An electric power controller 2 converts a direct current into an alternating current after voltage of DC power of the battery 3 is raised, and supplies the alternating current to the motor 21. When a driver steps a brake, the motor 21 generates power by using deceleration energy of a vehicle. AC power acquired by power generation is converted into a direct current by the electric power controller 2, and is further reduced in voltage to be used for charging the battery 3. The battery 3 includes a current sensor 13.

The electric power controller 2 includes a pair of voltage converters 10a, 10b, an inverter 20, and two capacitors (a filter capacitor 14, and a smoothing capacitor 15). The pair of voltage converters 10a, 10b is connected to each other in parallel between a low-voltage end 17 and a high-voltage end 18.

The voltage converters 10a, 10b each have a raising voltage function of raising voltage of the battery 3 to be applied to the low-voltage end 17 and outputting the voltage from the high-voltage end 18, and a lowering voltage function of lowering voltage of electric power from the inverter 20 to be applied to the high-voltage end 18 and outputting the voltage to the low-voltage end 17. That is, the voltage converters 10a, 10b each are a two-way DC-DC converter. The electric power from the inverter 20 is DC power that is acquired by converting AC power generated by the motor 21 with the inverter 20.

The first voltage converter 10a includes two transistors 5a, 6a, two diodes 7a, 8a, a reactor 4a, and a current sensor 12a. The two transistors 5a, 6a are connected to each other in series. The series connection of the two transistors 5a, 6a is formed between a cathode 18a and an anode 18b of the high-voltage end 18. The two diodes 7a, 8a are connected to the transistors 5a, 6a, respectively, in antiparallel. The reactor 4a is connected at its one end to a midpoint in the series connection of the two transistors 5a, 6a. The reactor 4a is connected at its other end to the cathode 17a of the low-voltage end 17. The filter capacitor 14 is connected between the cathode 17a and the anode 17b of the low-voltage end 17. The anode 17b of the low-voltage end 17 is directly connected to the anode 18b of the high-voltage end 18. The transistor 5a and the diode 8a are mainly involved in lowering voltage operation, and the transistor 6a and the diode 7a are mainly involved in raising voltage operation. A circuit configuration and operation of the voltage converter 10a of FIG. 1 are well known, so that detailed description is eliminated. The current sensor 12a measures a current flowing through the reactor 4a.

The second voltage converter 10b includes two transistors 5b, 6b, two diodes 7b, 8b, a reactor 4b, and a current sensor 12b. The second voltage converter 10b has the same structure and function as those of the first voltage converter 10a, so that description of the second voltage converter 10b is eliminated. The electric power controller 2 includes the pair of voltage converters 10a, 10b of the same type that are connected to each other in parallel to distribute a load.

The smoothing capacitor 15 is connected between the cathode 18a and the anode 18b of the high-voltage end 18. The smoothing capacitor 15 reduces pulsation of a current flowing between the pair of voltage converters 10a, 10b, and the inverter 20.

The inverter 20 converts DC power of the battery 3, with voltage raised by the voltage converters 10a, 10b, into three-phase AC electric power, and supplies the three-phase AC electric power to the motor 21. In addition, the inverter 20 converts three-phase AC electric power generated by the motor 21 into DC power, and supplies the DC power to the voltage converters 10a, 10b. Illustration and description of a specific circuit configuration of the inverter 20 are eliminated. The inverter 20 includes current sensors 19a to 19c in its respective three-phase AC output lines.

The voltage converters 10a, 10b, and the inverter 20, are controlled by a controller 9. The controller 9 causes the transistors 5a, 5b, 6a, 6b of the voltage converters 10a, 10b to be driven based on measurement values of the current sensor 13 of the battery 3, and the current sensors 12a, 12b provided in the voltage converter 10a, 10b, respectively. The controller 9 also controls the inverter 20 based on measurement values of the current sensors 19a to 19c provided in the respective three-phase AC output lines of the inverter 20.

The electric power controller 2 includes a total of the five current sensors 12a, 12b, 19a to 19c. The electric power controller 2 includes a failure detection function of detecting a failure of each of the current sensors 12a, 12b, 19a to 19c. Subsequently, the failure detection function will be described. A total of a U-phase current, a V-phase current, and a W-phase current of three-phase AC is always zero. Thus, when a total of measurement values of three current sensors 19a to 19c provided respective output lines of a three-phase AC is not zero, it can be detected that any one of the current sensors 19a to 19c fails. Meanwhile, another loading device (not illustrated) is connected between the battery 3 and the electric power controller 2, so that a measurement value of the current sensor 13 of the battery 3 is not equal to a total of measurement values of the current sensors 12a, 12b of the corresponding pair of voltage converters 10a, 10b. Each of the current sensors 12a, 12b has another failure detection function. The failure detection functions of each of the current sensors 12a, 12b will be described below.

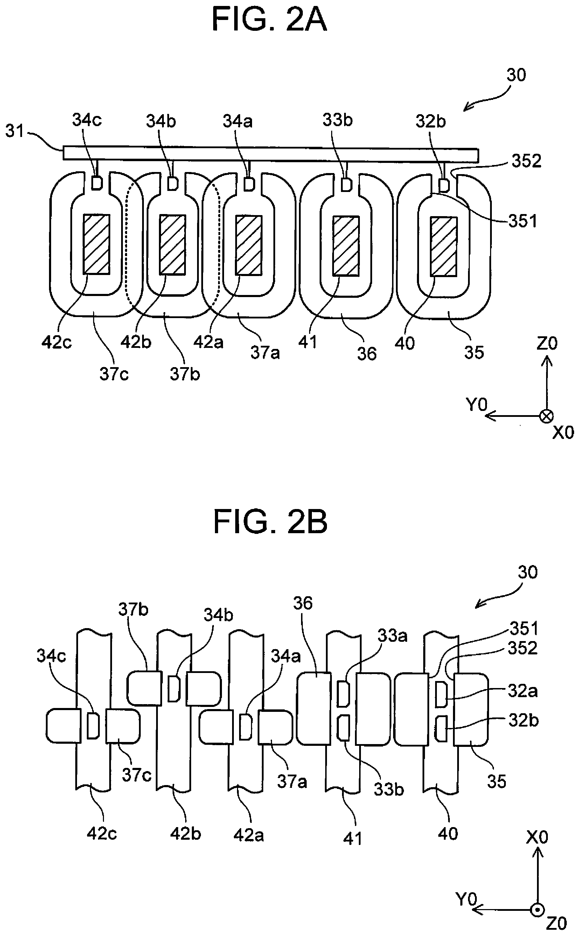

The five current sensors 12a, 12b, 19a to 19c are integrated into one sensor unit. With reference to FIGS. 2A and 2B, a current sensor unit 30 will be described. FIG. 2A is a front view of the current sensor unit 30, and FIG. 2B is a plan view of the current sensor unit 30. A reference numeral 40 indicates a bus bar 40 that forms a series connection between the reactor 4a and the two transistors 5a, 6a of the voltage converter 10a. The "bus bar" is a conductor to transmit a large current with a low loss, and specifically is a long slender metal plate of copper. A reference numeral 41 indicates a bus bar 41 that forms a series connection between the reactor 4b and the two transistors 5b, 6b of the voltage converter 10b. Reference numerals 42a to 42c indicate the corresponding bus bars of respective three-phase AC output lines of the inverter 20.

FIGS. 2A and 2B each show an X0Y0Z0 coordinate system that indicates a global coordinate system. The global coordinate system has an X0-axis that is identical to an extending direction of each of the bus bars 40, 41, 42a to 42c. While a local rectangular coordinate system unique to each sensor chip will be defined below, it is noted that a relative direction with respect to the bus bars 40, 41, 42a to 42c, and magnetism-collecting cores 35, 36, 37a to 37c described below, of the global coordinate system (X0Y0Z0 coordinate system), is always identical in subsequent drawings. In other words, the global coordinate system in the present specification is fixed to a magnetism-collecting core.

The current sensor unit 30 includes: the magnetism-collecting cores 35, 36, 37a to 37c each in the shape of a ring surrounding the corresponding one of the bus bars; the sensor chips 32a, 32b, 33a, 33b, 34a to 34c each being disposed in a gap of the corresponding one of the magnetism-collecting cores; a sensor controller 31; and a resin molding sealing the components above. Each of the bus bars also extends through the resin molding. In FIGS. 2A and 2B, the resin molding is not illustrated. In FIG. 2B, the sensor controller 31 is also not illustrated along with the resin mold. The resin molding allows each of the magnetism-collecting cores 35, 36, 37a to 37c, the sensor chips 32a, 32b, 33a, 33b, 34a to 34c, and the sensor controller 31, to have a fixed relative position with respect to the corresponding one of the bus bars.

The magnetism-collecting core 35 is in the shape of a ring, and the ring is disposed so as to surround the bus bar 40. In the magnetism-collecting core 35, the ring is parted at its one place. A space generated by parting is referred to as a gap. The two sensor chips 32a, 32b are disposed in the gap of the magnetism-collecting core 35. The magnetism-collecting core 36 is also in the shape of a ring whose one place is parted, and the ring is disposed so as to surround the bus bar 41. The two sensor chips 33a, 33b are also disposed in a gap of the magnetism-collecting core 36. The magnetism-collecting core 37a is disposed so as to surround the bus bar 42a, and the one sensor chip 34a is disposed in a gap of the magnetism-collecting core 37a. The magnetism-collecting core 37b is disposed so as to surround the bus bar 42b, and the one sensor chip 34b is disposed in a gap of the magnetism-collecting core 37b. The magnetism-collecting core 37c is disposed so as to surround the bus bar 42c, and the one sensor chip 34c is disposed in a gap of the magnetism-collecting core 37c. The two sensor chips are disposed in the gap of each of the magnetism-collecting cores 35, 36, along an extending direction of the corresponding one of the bus bars, so that the magnetism-collecting cores 35, 36 is larger than the other magnetism-collecting cores 37a to 37c in width in an X0-axis direction. The global coordinate system has a Y0-axis whose direction corresponds to a normal direction of each of end faces 351, 352 facing the gap of the magnetism-collecting core 35 (and the other magnetism-collecting cores).

Each of the sensor chips houses a magnetoelectric transducer. The magnetoelectric transducer is specifically a hall element in which electromotive force changes in accordance with a level of a magnetic field detected. The magnetism-collecting core collects a magnetic field caused by a current flowing through each of the bus bars. A level of the magnetic field generated is proportional to a current flowing through each of the bus bars. The magnetoelectric transducer of the sensor chip disposed in the gap of the magnetism-collecting core measures a magnetic field (magnetic flux) passing through the gap of the magnetism-collecting core. The sensor chips 32a, 32b, 33a, 33b, 34a to 34c are connected to the sensor controller 31. The sensor controller 31 determines magnitude of current flowing through each of the bus bars from a level of a magnetic field (magnetic flux) measured by each of the sensor chips (magnetoelectric transducers), and outputs the determined result to the controller 9. The magnetism-collecting core 35, the sensor chips 32a, 32b, and the sensor controller 31 correspond to the current sensor 12a of FIG. 1. The magnetism-collecting core 36, the sensor chips 33a, 33b, and the sensor controller 31 correspond to the current sensor 12b of FIG. 1. The magnetism-collecting core 37a, the sensor chip 34a, and the sensor controller 31 correspond to the current sensor 19a of FIG. 1. The magnetism-collecting core 37b, the sensor chips 34b, and the sensor controller 31 correspond to the current sensor 19b of FIG. 1. The magnetism-collecting core 37c, the sensor chips 34c, and the sensor controller 31 correspond to the current sensor 19c of FIG. 1.

The sensor chips 32a, 32b, 33a, 33b, 34a to 34c are configured such that an output current changes in accordance with a level of a magnetic field detected by each of the magnetoelectric transducers inside the corresponding sensor chips. The magnetoelectric transducer can only detect a magnetic field in a predetermined direction, and the direction is called a magnetic induction direction. The magnetic induction direction includes positive and negative directions, and the positive direction is a direction in which a sensor output for a magnetic flux passing through the sensor chip (magnetoelectric transducer) is a positive value. In other words, each of the sensor chips 32a, 32b, 33a, 33b, 34a to 34c outputs a current with a positive value when receiving a magnetic field in a direction identical to its magnetic induction direction, and outputs a current with a negative value when receiving a magnetic field in a direction opposite to its magnetic induction direction.

The failure detection function of the current sensor will be described below. As described above, a total of three-phase AC outputs is always zero. The sensor controller 31 outputs a signal (error signal) to the controller 9, the signal indicating that anomaly occurs in any one of the sensor chips 34a to 34c, when an absolute value of a total of measurement values of the sensor chip 34a to 34c exceeds a predetermined threshold value.

The current sensor including the magnetism-collecting core 35, the sensor chips 32a, 32b, and the sensor controller 31, has a failure detection function different from that of the current sensor including the magnetism-collecting core 36, the sensor chips 33a, 33b, and the sensor controller 31. The failure detection function of the current sensor including the magnetism-collecting core 35, the sensor chips 32a, 32b, and the sensor controller 31, will be described. The description below can be applied to the current sensor including the magnetism-collecting core 36, the sensor chips 33a, 33b, and the sensor controller 31.

The sensor chips 32a, 32b each are the same type (same shape), and are disposed in a gap of the magnetism-collecting core 35. When the sensor chips 32a, 32b are normal, outputs of the respective sensor chips are equal to each other. When there is a difference equal to or more than a predetermined value between outputs of the respective sensor chips 32a, 32b, it can be found that any one of the sensor chips 32a, 32b fails. The sensor controller 31 outputs an error signal (a signal indicating that anomaly occurs) when a difference in output (a difference in absolute value of an output) of the two sensor chips 32a, 32b disposed in the gap of the magnetism-collecting core 35 exceeds a predetermined threshold value. The predetermined threshold value is set based on a tolerance of difference in output when the two sensor chips 32a, 32b normally operate.

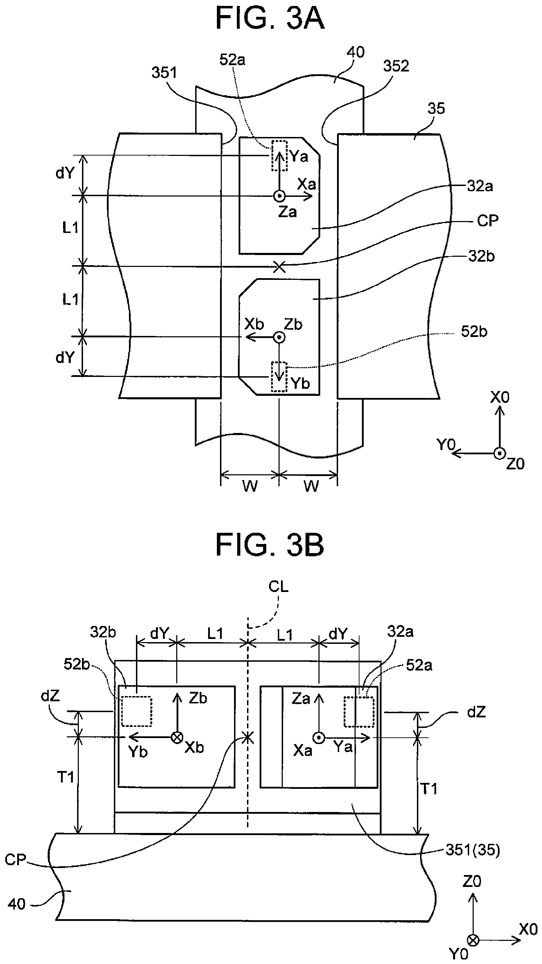

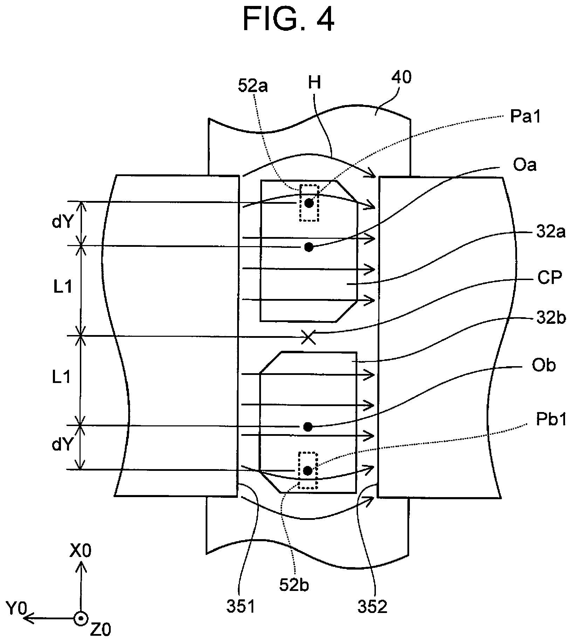

It is preferable that a difference in outputs of the two sensor chips 32a, 32b disposed in the gap of the magnetism-collecting core 35 is close to zero as much as possible. Thus, the two sensor chips 32a, 32b are disposed in the gap of the magnetism-collecting core 35 so as to receive the same magnetic field in level. Specifically, the two sensor chips 32a, 32b are disposed one by one on the corresponding sides across a straight line passing through a gap center, and are disposed at respective positions equidistant from the gap center, as viewed from a normal direction of each of the end faces 351, 352 facing the gap of the magnetism-collecting core 35. This point will be described below in detail with reference to FIGS. 3A, 3B, and 4. The gap center as viewed from the normal direction is an end face center, in other words. Hereinafter, "the gap center as viewed from the normal direction of the end faces" may be simply referred to as "the end face center".

Due to circumstances in manufacture or design, a magnetoelectric transducer in each of the sensor chips may be disposed at a position which deviates from the chip center in a predetermined direction. When the two sensor chips are aligned in the same posture in the gap, as viewed from the normal direction of the end faces, a magnetoelectric transducer of one of the sensor chips is closer to the gap center than the chip center, and a magnetoelectric transducer of the other of the sensor chips is farther away from the gap center than the chip center. That is, even if the two sensor chips are disposed at corresponding symmetric positions across the gap center as viewed from the normal direction, each of magnetoelectric transducers in the two respective sensor chips may be different in distance from the end face center. When the magnetoelectric transducers in the two respective sensor chips are different from each other in distance from the gap center, absolute values of outputs of the two respective magnetoelectric transducers (sensor chips) are different from each other. It is desirable that a threshold value for determining a failure is small in a failure detection function based on an output difference between the two sensor chips 32a, 32b. The two sensor chips 32a, 32b are disposed by making efforts such that an output difference between the two sensor chips does not increase even when a position of each of the magnetoelectric transducers in the respective sensor chips deviates from the center of the sensor chips. A placement of the sensor chips 32a, 32b in the gap will be described below.

FIG. 3A is an enlarged plan view of a periphery of a gap of the magnetism-collecting core 35, and FIG. 3B is a placement diagram of the sensor chips 32a, 32b as viewed from the normal direction of the end faces 351 of the magnetism-collecting core 35, facing the gap. The normal direction of the end faces 351 corresponds to a direction of the Y0-axis of the global coordinate system. A magnetoelectric transducer 52a is built in the sensor chip 32a, and a magnetoelectric transducer 52b is built in the sensor chip 32b. The magnetoelectric transducers 52a, 52b each are a hall element that can detect a magnetic field (magnetic flux) passing through the element in a specific direction. As described above, a direction of a magnetic field (magnetic flux) detected by the element is called a magnetic induction direction.

Here, a local rectangular coordinate system unique to each sensor chip will be defined. The local rectangular coordinate system is introduced to identify posture of each sensor chip with respect to the magnetism-collecting core 35 (global coordinate system). The local rectangular coordinate system has an original point that is set at the center of the sensor chip. The local rectangular coordinate system has an X-axis that is identical to a magnetic induction direction of a built-in magnetoelectric transducer. The X-axis of the local rectangular coordinate system has a positive direction in which an output of the sensor chip increases as a magnetic field (magnetic flux) increases. In other words, the positive direction in the X-axis is a direction in which intensity of a magnetic field (magnetic flux) and an output of the sensor chip have a positive correlation. The local rectangular coordinate system has a Y-axis that is in a direction orthogonal to the magnetic induction direction (or the X-axis), and that is identical to a specific direction of the sensor chip. A Z-axis is set as a direction orthogonal to the X-axis and the Y-axis. As illustrated in FIGS. 3A and 3B, the local rectangular coordinate system of the sensor chip 32a is indicated as Xa, Ya, and Za, and the local rectangular coordinate system of the sensor chip 32b is indicated as Xb, Yb, and Zb.

The sensor chips 32a, 32b each are the same type chip, a position of each of the magnetoelectric transducers 52a, 52b inside the corresponding sensor chips 32a, 32b deviates from the center of the corresponding one of the sensor chips in the same direction. An actual position of each of the magnetoelectric transducers 52a, 52b deviates from the original point of the local rectangular coordinate system by dY in a positive direction in the Y-axis (a Ya-axis and a Yb-axis).

The two sensor chips 32a, 32b are disposed such that the center (or the original point of the local rectangular coordinate system) of each of the chips is positioned at a midpoint in a space between the pair of end faces 351, 352 facing the gap of the magnetism-collecting core 35. As illustrated in FIG. 3A, the center of each of the magnetoelectric transducers (or the original point of each of the local rectangular coordinate systems) is away from each of the end faces 351, 352 by a distance W.

In addition, the two sensor chips 32a, 32b are disposed one by one on the corresponding sides across a straight line (a center line CL) passing through a gap center CP (an end face center), orthogonal to the bus bar 40, as viewed from the normal direction (a Y0 direction in the drawings) of each of the end faces 351, 352 facing the gap of the magnetism-collecting core 35. Further, the two sensor chips 32a, 32b each are disposed at a position equidistant from the gap center CP, as viewed from the normal direction of each of the end faces 351, 352. That is, in FIGS. 3A and 3B, a distance L1 between the gap center CP and the original point of the local rectangular coordinate system of the sensor chip 32a is equal to a distance L1 between the gap center CP and the original point of the local rectangular coordinate system of the sensor chip 32b. Then the sensor chips 32a, 32b are disposed such that the Y-axes (the Ya-axis and the Yb-axis) of the respective local rectangular coordinate systems of the corresponding sensor chips are along directions opposite to each other. As illustrated in FIGS. 3A and 3B, the Ya-axis of the local rectangular coordinate system of the sensor chip 32a, and the Yb-axis of the local rectangular coordinate system of the sensor chip 32b, are along directions opposite to each other.

The placement described above allows the magnetoelectric transducers 52a, 52b to be positioned at respective positions away from the gap center CP by a distance "L1 + dY" in the corresponding sensor chips 32a, 32b. The placement of FIG. 3B is as follows in other words. The two sensor chips 32a, 32b are disposed in an axially symmetric manner to the straight line (center line CL) passing through the gap center CP (the end face center), including posture of the sensor chips, as viewed from the normal direction of the end faces. The center line CL corresponds to a perpendicular bisector at the center (the original point local of the coordinate system) of a space between the two sensor chips 32a, 32b. Thus, the placement of the two sensor chips 32a, 32b can be also described as follows in other words. The two sensor chips 32a, 32b are disposed such that a perpendicular bisector at the center of a space between the two sensor chips passes through the gap center CP (the end face center), and are disposed so as to be in a mirror symmetric manner to the perpendicular bisector including posture of the two sensor chips, as viewed from the normal direction of the end faces.

FIG. 4 is a schematic diagram showing a relationship between a magnetoelectric transducer and a magnetic field in the gap. Arrows H each indicate a magnetic field (magnetic field H). The magnetic field H is vertically symmetric to the gap center CP (upper and lower portions of FIG. 4). The magnetic field H is parallel and uniform near the gap center CP, but is curved as being away from the gap center CP. The sensor chips 32a, 32b include the respective magnetoelectric transducers that are positioned at the corresponding places Pa1, Pb1 deviates by dY from the center of the corresponding sensor chips (original points Oa, Ob of respective local rectangular coordinate systems) in the corresponding one of Ya, Yb directions of the local rectangular coordinate system. The Ya-axis and the Yb-axis in the local rectangular coordinate system are along the corresponding directions opposite to each other, so that a distance from the gap center CP to each of the magnetoelectric transducers 52a, 52b is "L1 + dY" in the corresponding one of the sensor chips 32a, 32b, and thus the magnetic field H and each of the magnetoelectric transducers 52a, 52b have the same relative relationship. As a result, even when a position of each of the magnetoelectric transducers in the respective sensor chips deviates from the corresponding chip center, an output difference between the two sensor chips 32a, 32b does not increase.

With reference to FIG. 3B, a relationship between the magnetoelectric transducers 52a, 52b built in the two corresponding two sensor chips 32a, 32b in a Z0 direction will be described. It is assumed that a position in a Z direction of the local rectangular coordinate system of the magnetoelectric transducer deviates from the chip center by dZ. The chip center (the original point of the local rectangular coordinate system) is at a position away from the bus bar 40 by a distance T1. Then each of the magnetoelectric transducers 52a, 52b is away from the gap center CP (the end face center) by dZ, as viewed from the normal direction of the end faces, so that a distance from the bus bar 40 to each of the magnetoelectric transducers 52a, 52b is equal to "T1 + dZ". In addition, a distance from the gap center CP to each of the magnetoelectric transducers 52a, 52b in the Z0 direction is equal to dZ. Thus, even when axes (a Za-axis and a Zb-axis) of the respective local rectangular coordinate systems of the two corresponding sensor chips 32a, 32b are along the same direction in a direction (the Z0 direction of the global coordinate system) intersecting with an aligned direction of the two magnetoelectric transducer 52a, 52b, an output difference between the two sensor chips 32a, 32b does not increase.

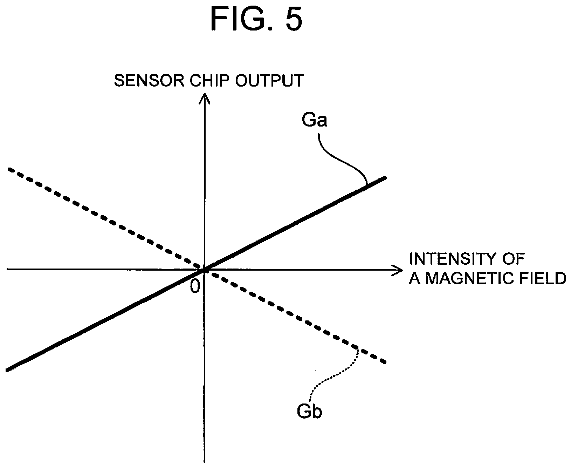

The two sensor chips 32a, 32b are disposed such that the X-axes indicating the respective magnetic induction directions of the corresponding magnetoelectric transducers 52a, 52b are along directions opposite to each other. This feature provides the following advantage. FIG. 5 is a graph having a horizontal axis that represents intensity of a magnetic field, and a vertical axis that represents a sensor chip output. As described above, an output of each of the sensor chips 32a, 32b has a positive value when a direction of a magnetic field is identical to the magnetic induction direction (the positive direction in the X-axis of the local rectangular coordinate system). When the direction of the magnetic field is opposite to the magnetic induction direction (the positive direction in the X-axis of the local rectangular coordinate system), an output of each of the sensor chips 32a, 32b has a negative value. This forms a graph in which outputs of the respective sensor chips 32a, 32b, in which the X-axes of the respective local rectangular coordinate systems are along directions opposite to each other, are intersected with each other at the original point as illustrated in FIG. 5. In the graph, a plotted line Ga indicates outputs of the sensor chip 32a, and a plotted line Gb indicates outputs of the sensor chip 32b. From FIG. 5, it can be understood that an output difference (a difference in an absolute value of an output) between the two sensor chips 32a, 32b can be acquired by only simply adding outputs of the sensor chip 32a and the sensor chip 32b with an adder. This simplifies a circuit configuration of the sensor controller 31 that outputs an error signal when an output difference between the two sensor chips 32a, 32b exceeds a predetermined threshold value.

Features of the current sensor including the sensor chips 32a, 32b, the magnetism-collecting core 35, and the sensor controller 31 are described as follows. The magnetism-collecting core 35 is in the shape of a ring whose one place is parted to form a gap. The ring surrounds a bus bar (a conductor through which a current to be measured flows). The sensor chips 32a, 32b each are the same type (same shape), and are disposed in the gap of the magnetism-collecting core 35. The sensor chip 32a houses the magnetoelectric transducer 52a, and the sensor chip 32b houses the magnetoelectric transducer 52b. The two sensor chips 32a, 32b are disposed one by one on the corresponding sides across the straight line (center line CL) passing through the gap center CP (the end face center), orthogonal to the bus bar 40, as viewed from the normal direction of the pair of end faces 351, 352 facing the gap of the magnetism-collecting core 35. The two sensor chips 32a, 32b each are disposed at a position equidistant from the gap center CP, as viewed from the normal direction. The original point is set at the center of each of the sensor chips 32a, 32b, and the local rectangular coordinate system is defined such that the X-axis is along the magnetic induction direction of each of the built-in magnetoelectric transducers 52a, 52b, and the Y-axis and the Z-axis each are orthogonal to the magnetic induction direction. At this time, the two sensor chips 32a, 32b are disposed such that the X-axes of the respective local rectangular coordinate systems of the two corresponding sensor chips are along the normal direction of the end faces 351, and the Y-axes thereof extend parallel to the aligned direction of the two sensor chips 32a, 32b and are along directions opposite to each other. In other words, the two sensor chips 32a, 32b are disposed such that the magnetic induction directions thereof, in which a positive value is output for a magnetic flux, are along directions opposite to each other in the normal direction of the end faces of the magnetism-collecting core, and are disposed so as to be in an axially symmetric manner to the straight line (center line CL) passing through the gap center CP (the end face center), including posture of the sensor chips, as viewed from the normal direction.

The sensor controller 31 outputs an error signal when an output difference (a difference in an absolute value of an output) between the two sensor chips 32a, 32b (magnetoelectric transducers 52a, 52b) exceeds a predetermined threshold value. The sensor controller 31 calculates and outputs a value of a current flowing through the bus bar 40 based on at least one of outputs of the two respective sensor chips 32a, 32b.

The two sensor chips 32a, 32b are disposed such that the X-axes of the respective local rectangular coordinate systems of the two corresponding sensor chips 32a, 32b are along directions opposite to each other. This placement enables the sensor controller 31 to acquire an output difference (difference in an absolute value of an output) between the two sensor chips 32a, 32b with a simple circuit configuration.

The placement of the sensor chips 33a, 33b illustrated in FIG. 2 is also identical to the placement of the sensor chips 32a, 32b, so that an equivalent advantage can be acquired.

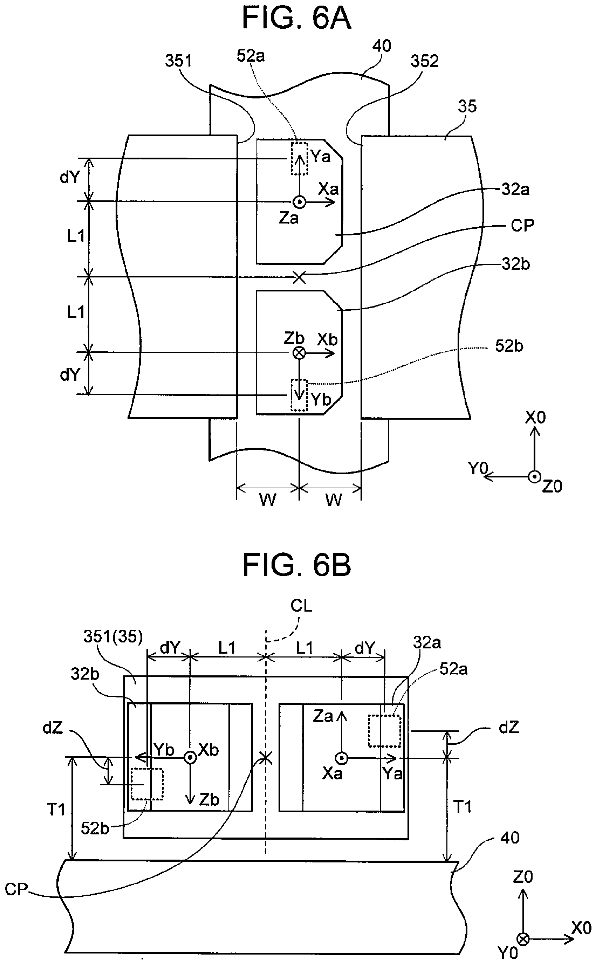

With reference to FIGS. 6A and 6B, another placement example of the two sensor chips 32a, 32b will be described. FIGS. 6A and 6B correspond to FIGS. 3A and 3B, respectively. In FIGS. 3A and 3B, the X-axes (the Xa-axis and the Xb-axis) of the respective local rectangular coordinate systems of the corresponding sensor chips 32a, 32b are along directions opposite to each other. In a modification of FIGS. 6A and 6B, the X-axes (the Xa-axis and the Xb-axis) of the respective local rectangular coordinate systems of the corresponding sensor chips 32a, 32b are along the same direction. Instead, the Z-axes (the Za-axis and the Zb-axis) of the respective local coordinate systems are along directions opposite to each other. The Y-axes (the Ya-axis and the Yb-axis) of the respective local rectangular coordinate systems extending in the aligned direction of the two sensor chips 32a, 32b are along directions opposite to each other as with FIGS. 3A and 3B. The placement of FIGS. 6A and 6B also allows each of the magnetoelectric transducers 52a, 52b of the corresponding sensor chips 32a, 32b to be positioned at an equidistance (L1+dY) from the gap center CP (the end face center) as viewed from the normal direction of the end faces when a position of each of the magnetoelectric transducers 52a, 52b in the respective sensor chips deviates from the chip center (the original point of the local rectangular coordinate system) by dY in the Y-axis direction of the local rectangular coordinate system. Even in this case, an output difference between the two sensor chips 32a, 32b does not increase.

In the placement of FIG. 6B, while the two sensor chips 32a, 32b are positioned in an axially symmetric manner to the center line CL, both of the Z-axes and the Y-axes of the respective local coordinate systems are along opposite directions, and thus posture is not mirror symmetric. The two sensor chips 32a, 32b are disposed in a point symmetric manner to the gap center CP (the end face center) as viewed from the normal direction of the end faces. The "point symmetric" also includes posture of the sensor chips. The two sensor chips being point symmetric to the gap center CP including posture thereof means that not only positions of the two respective sensor chips are point symmetric to the gap center CP, but also contours of the respective sensor chips match each other when one of the sensor chips is turned by 180 degrees around its center to be laid on top of the other of the sensor chips.

In the placement of FIGS. 6A and 6B, the Z-axes (the Za-axis and the Zb-axis) of the respective local coordinate systems are along directions opposite to each other. When the centers (chip centers) of the respective sensor chips 32a, 32b are positioned in a point symmetric manner to the gap center CP as viewed from the normal direction of the end faces, an output difference between the two sensor chips does not increase even when positions of the respective magnetoelectric transducers deviate from the corresponding chip centers. As illustrated in FIG. 6B, even when positions of the magnetoelectric transducers 52a, 52b of the corresponding sensor chips 32a, 32b deviate from the corresponding chip centers by dZ in the Z-axis positive direction of each of the local rectangular coordinate systems, distances from the gap center CP to the respective magnetoelectric transducers 52a, 52b becomes equal to each other. As a result, relative relationships between the respective magnetoelectric transducers 52a, 52b and a magnetic field becomes identical to each other, so that an output difference between the respective sensor chips 32a, 32b does not increase. This advantage can be acquired when the sensor chips 32a, 32b are disposed in a point symmetric manner to the gap center CP as viewed from the normal direction of the end faces 351.

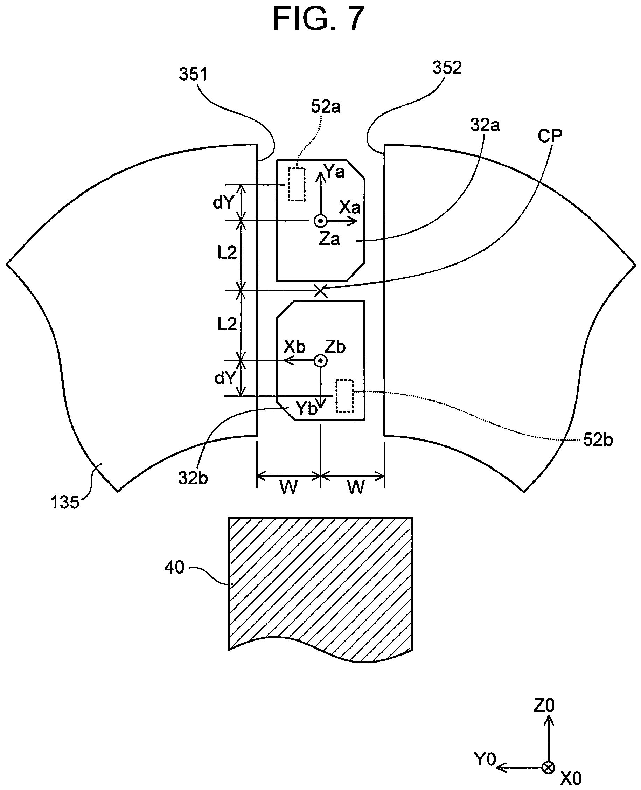

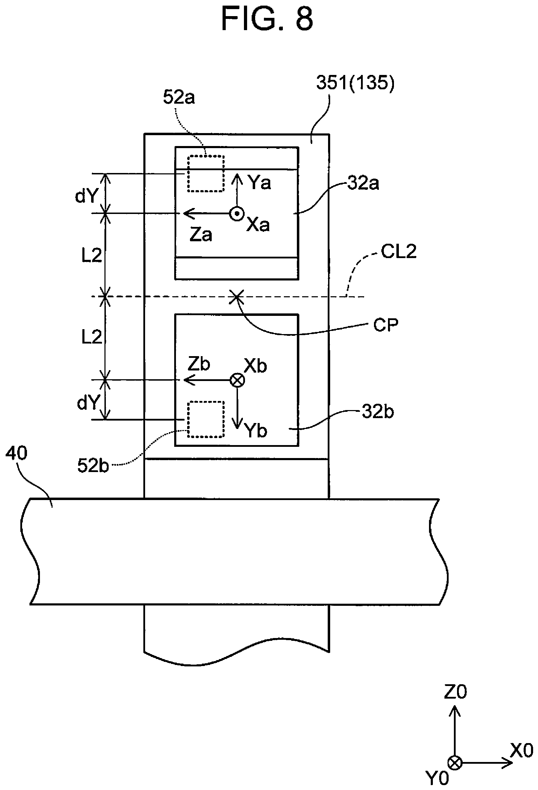

With reference to FIGS. 7 and 8, yet another placement example of two sensor chips 32a, 32b will be described. In the placement example of FIGS. 7 and 8, the two sensor chips 32a, 32b are disposed one by one on the corresponding sides across a straight line (center line CL2) passing through a gap center CP, parallel to the bus bar 40, as viewed from the normal direction (the Y0 direction of the global coordinate system) of each of end faces 351, 352 of a magnetism-collecting core 135.

The two sensor chips 32a, 32b are disposed so as to be positioned in the middle in a space between the pair of end faces 351, 352 facing a gap of a magnetism-collecting core 135. As illustrated in FIG. 7, the two sensor chips 32a, 32b each are disposed at a position away from any one of the end faces 351, 352 by a distance W. In addition, the two sensor chips 32a, 32b each are disposed at a position equidistant (distance L2) from the gap center CP (the end face center), as viewed from the normal direction of the end faces 351. Then, an original point is set at the center of each of the sensor chips 32a, 32b, and a local rectangular coordinate system is defined such that the X-axis is along a magnetic induction direction of each of magnetoelectric transducers 52a, 52b inside the corresponding sensor chips 32a, 32b, and the Y-axis and the Z-axis each are along a direction orthogonal to the magnetic induction direction. At this time, the two sensor chips 32a, 32b are disposed such that the X-axes of the respective local rectangular coordinate systems of the two corresponding sensor chips 32a, 32b are along the normal direction, and the Y-axes thereof extend parallel to an aligned direction of the two sensor chips 32a, 32b and are along directions opposite to each other. In the example of FIGS. 7 and 8, a position of each of the magnetoelectric transducers 52a, 52b in the corresponding chips deviates from the corresponding one of chip centers by dY in the Y-axis positive direction of the local rectangular coordinate system. As illustrated in FIGS. 7 and 8, in this case, each of the magnetoelectric transducers 52a, 52b in the corresponding sensor chips 32a, 32b is positioned away from the gap center CP by a distance "L2 + dY". The magnetoelectric transducers 52a, 52b each are positioned at an equidistance from the gap center CP, so that an output difference between the two sensor chips 32a, 32b does not increase.

In the placement of FIG. 8, the two sensor chips 32a, 32b are also disposed in a point symmetric manner to the gap center CP (the end face center) including posture of the two sensor chips, as viewed from the normal direction of the end faces facing the gap.

A consideration of the techniques described in the example will be described. The features of the placement of FIGS. 3A and 3B can be expressed along with the features of the placement of FIG. 8 as follows. It is desirable that the two sensor chips are disposed one by one on the corresponding sides across the straight line CL passing through the gap center CP, orthogonal to the bus bar (conductor), or across the straight line CL2 passing through the gap center CP, parallel to the bus bar (conductor), as viewed from the normal direction of the end faces facing the gap of the magnetism-collecting core. The gap center CP means the center (the end face center) of a contour of each of the end faces facing the gap of the magnetism-collecting core, as viewed from the normal direction of the end faces. When a contour of each of the end faces facing the gap of the magnetism-collecting core is a circular shape, the two sensor chips may be disposed one by one on the corresponding sides across a straight line in any direction as viewed from the normal direction of the end faces when the straight line passes through the gap center.

Each of the pair of end faces across the gap may be formed in a vertically and bilaterally symmetric shape, as viewed from the normal direction. While the pair of end faces across the gap does not need to be the same shape, each of the end faces may be vertically and bilaterally symmetric to the end face center.

In every placement example of the example, the two sensor chips are disposed such that the gap center is positioned at a midpoint of a line segment connecting between sensor centers of the two respective sensor chips as viewed from the normal direction of the end faces of the magnetism-collecting core. In other words, in the placement example of FIGS. 3A and 3B, and that of 6A and 6B, the two sensor chips are disposed such that their centers each are positioned on a straight line passing through the gap center, parallel to an extending direction of the bus bar 40, as viewed from the normal direction of the end faces of the magnetism-collecting core. In other words, in the placement example of FIGS. 7 and 8, the two sensor chips are disposed such that their centers each are positioned on a straight line passing through the gap center, orthogonal to the bus bar 40, as viewed from the normal direction of the end faces of the magnetism-collecting core.

While it is desirable that each of positions of the two respective sensor chips in the normal direction of the end faces of the magnetism-collecting core is a midpoint in a space between the pair of end faces, each of the positions is not limited to the midpoint.

The three kinds of placement example of the two sensor chips 32a, 32b and their advantages also can be applied to the sensor chips 33a, 33b, and the magnetism-collecting core 36, illustrated in FIGS. 2A and 2B.

In the example described above, the magnetoelectric transducer is housed in the sensor chip at a position deviates from the chip center. When the magnetoelectric transducer is disposed in the sensor chip at the chip center, it seems that the two sensor chips may be disposed in the gap in the same posture. However, even when a position of the magnetoelectric transducer in the chip in design is the chip center, it is preferable that the two sensor chips are disposed in an axially symmetric manner or a point symmetric manner. Even when a position of the magnetoelectric transducer in the chip in design is the chip center, a position of the magnetoelectric transducer in the chips may deviate from the position in design depending on unique characteristics of a manufacturing apparatus or a manufacturing process. The unique characteristics of the manufacturing apparatus or the manufacturing process are applied to all sensor chips manufactured, so that an actual position of each of the magnetoelectric transducers in the respective plurality of sensor chips deviates from the chip center in the same direction. That is, this applies the same state as that of the example described above. Even when a position of the magnetoelectric transducer in the sensor chip in design is the chip center, the technique disclosed in the present specification is effective.

The current sensor including the magnetism-collecting core 35 and the sensor chips 32a, 32b in the example corresponds to an example of a current sensor according to claims. The sensor controller 31 in the example corresponds to an example of a sensor controller according to claims.

While specific examples of the present invention are described above in detail, the examples are only described for example, and thus do not limit the scope of claims. The techniques according to claims include various variations and modifications of the specific examples described above for example.

## Claims

1. A current sensor for measuring a current flowing through a conductor, the current sensor comprising:
a magnetism-collecting core (35) having a ring shape of a ring surrounding a conductor, the ring having a gap at a part of the ring shape; and
two sensor chips (32a, 32b) housing respective magnetoelectric transducers (52a, 52b), and the two sensor chips being disposed in the gap, the two sensor chips (32a, 32b) being disposed such that a magnetic induction direction of each of the two sensor chips (32a,32b) is the same as a normal direction of end faces (351, 352) of the magnetism-collecting core, the end faces (351, 352) facing the gap, and **characterised in** the two sensor chips (32a, 32b) being disposed in a point symmetric manner to a center (CP) of the gap, as viewed from the normal direction,
wherein each of the magnetoelectric transducers is positioned at a position equidistant from the center (CP) of the gap.

2. A current sensor for measuring a current flowing through a conductor, the current sensor comprising:
a magnetism-collecting core (35) having a ring shape of a ring surrounding a conductor, the ring having a gap at a part of the ring one place to form a gap; and
two sensor chips (32a, 32b) housing respective magnetoelectric transducers (52a, 52b), and the two sensor chips (32a, 32b) being disposed in the gap, the two sensor chips (32a, 32b) being disposed such that a magnetic induction direction of each of the two sensor chips (32a, 32b) is the same as a normal direction of end faces (351, 352) of the magnetism-collecting core, the end faces (351, 352) facing the gap, and **characterised in** the two sensor chips (32a, 32b) being disposed in an axially symmetric manner to a straight line (CL) passing through a center of the gap,
wherein each of the magnetoelectric transducers is positioned at a position equidistant from the center (CP) of the gap.

3. The current sensor according to claim 1 or 2, further comprising a sensor controller (31), the sensor controller (31) being configured to output an error signal when an output difference between the two magnetoelectric transducers (52a, 52b) exceeds a predetermined threshold value.

4. The current sensor according to claim 3, wherein
the two sensor chips (32a, 32b) are disposed such that when the two sensor chips output positive values for a magnetic flux passing the gap respectively, a magnetic induction direction of one of the two sensor chips (32a, 32b) is opposite to the magnetic induction direction of the other one of the two sensor chips (32a, 32b).

## Patentansprüche

1. Stromsensor zum Messen eines Stroms, der durch einen Leiter fließt, wobei der Stromsensor umfasst:
einen Magnetismussammelkern (35), der eine Ringform eines Rings aufweist, der einen Leiter umgibt, wobei der Ring einen Spalt an einem Teil der Ringform aufweist, und
zwei Sensorchips (32a, 32b), die entsprechende magnetoelektrische Wandler (52a, 52b) unterbringen, und wobei die beiden Sensorchips in dem Spalt angeordnet sind, die beiden Sensorchips (32a, 32b) derart angeordnet sind, dass eine magnetische Induktionsrichtung von jedem der beiden Sensorchips (32a, 32b) die gleiche wie eine Normalrichtung von Endseiten (351, 352) des Magnetismussammelkerns ist und die Endseiten (351, 352) dem Spalt zugewandt sind, und
**dadurch gekennzeichnet, dass** die beiden Sensorchips (32a, 32b) aus der Normalrichtung betrachtet punktsymmetrisch zu einer Mitte (CP) des Spalts angeordnet sind,
wobei jeder der magnetoelektrischen Wandler an einer Position positioniert ist, die abstandsgleich von der Mitte (CP) des Spalts ist.

2. Stromsensor zum Messen eines Stroms, der durch einen Leiter fließt, wobei der Stromsensor umfasst:
einen Magnetismussammelkern (35), der eine Ringform eines Rings aufweist, der einen Leiter umgibt, wobei der Ring einen Spalt an einem Teil der einen Stelle des Rings aufweist, um einen Spalt zu bilden, und
wobei die beiden Sensorchips (32a, 32b) entsprechende magnetoelektrische Wandler (52a, 52b) unterbringen und die beiden Sensorchips (32a, 32b) in dem Spalt angeordnet sind, die beiden Sensorchips (32a, 32b) derart angeordnet sind, dass eine magnetische Induktionsrichtung von jedem der beiden Sensorchips (32a, 32b) die gleiche wie eine Normalrichtung von Endseiten (351, 352) des Magnetismussammelkerns ist und die Endseiten (351, 352) dem Spalt zugewandt sind, und
**dadurch gekennzeichnet, dass** die beiden Sensorchips (32a, 32b) achsensymmetrisch zu einer geraden Linie (CL) angeordnet sind, die durch eine Mitte des Spalts verläuft,
wobei jeder der magnetoelektrischen Wandler an einer Position positioniert ist, die abstandsgleich von der Mitte (CP) des Spalts ist.

3. Stromsensor nach Anspruch 1 oder 2, ferner umfassend eine Sensorsteuereinrichtung (31), wobei die Sensorsteuereinrichtung (31) dazu ausgestaltet ist, ein Fehlersignal auszugeben, wenn eine Ausgangsdifferenz zwischen den beiden magnetoelektrischen Wandlern (52a, 52b) einen vorbestimmten Schwellenwert überschreitet.

4. Stromsensor nach Anspruch 3, wobei
die beiden Sensorchips (32a, 32b) derart angeordnet sind, dass, wenn die beiden Sensorchips positive Werte für einen magnetischen Fluss ausgeben, der jeweils den Spalt durchquert, eine magnetische Induktionsrichtung von einem der beiden Sensorchips (32a, 32b) der magnetischen Induktionsrichtung des anderen der beiden Sensorchips (32a, 32b) entgegengesetzt ist.

## Revendications

1. Capteur de courant pour la mesure d'un courant circulant à travers un conducteur, le capteur de courant comprenant :
un noyau de collecte de magnétisme (35) ayant une forme annulaire d'un anneau encerclant un conducteur, l'anneau ayant un interstice au niveau d'une partie de la forme annulaire ; et
deux puces de capteur (32a, 32b) hébergeant des transducteurs magnétoélectriques (52a, 52b) respectifs, et les deux puces de capteur étant disposées dans l'interstice, les deux puces de capteur (32a, 32b) étant disposées de sorte qu'une direction d'induction magnétique de chacune des deux puces de capteur (32a, 32b) soit la même qu'une direction normale de faces d'extrémité (351, 352) du noyau de collecte de magnétisme, les faces d'extrémité (351, 352) faisant face à l'interstice, et
**caractérisé en ce que** les deux puces de capteur (32a, 32b) sont disposées selon une symétrie ponctuelle par rapport à un centre (CP) de l'interstice, lorsqu'on l'observe depuis la direction normale,
dans lequel chacun des transducteurs magnétoélectriques est positionné à une position équidistante par rapport au centre (CP) de l'interstice.

2. Capteur de courant pour la mesure d'un courant circulant à travers un conducteur, le capteur de courant comprenant :
un noyau de collecte de magnétisme (35) ayant une forme annulaire d'un anneau encerclant un conducteur, l'anneau ayant un interstice au niveau d'une partie de l'anneau à un emplacement pour former un interstice ; et
deux puces de capteur (32a, 32b) hébergeant des transducteurs magnétoélectriques (52a, 52b) respectifs, et les deux puces de capteur (32a, 32b) étant disposées dans l'interstice, les deux puces de capteur (32a, 32b) étant disposées de sorte qu'une direction d'induction magnétique de chacune des deux puces de capteur (32a, 32b) soit la même qu'une direction normale de faces d'extrémité (351, 352) du noyau de collecte de magnétisme, les faces d'extrémité (351, 352) faisant face à l'interstice, et
**caractérisé en ce que** les deux puces de capteur (32a, 32b) sont disposées selon une symétrie axiale par rapport à une ligne droite (CL) passant par un centre de l'interstice,
dans lequel chacun des transducteurs magnétoélectriques est positionné à une position équidistante par rapport au centre (CP) de l'interstice.

3. Capteur de courant selon la revendication 1 ou 2, comprenant en outre un dispositif de commande de capteur (31), le dispositif de commande de capteur (31) étant configuré pour délivrer en sortie un signal d'erreur lorsqu'une différence de sortie entre les deux transducteurs magnétoélectriques (52a, 52b) dépasse une valeur seuil prédéterminée.

4. Capteur de courant selon la revendication 3, dans lequel
les deux puces de capteur (32a, 32b) sont disposées de sorte que lorsque les deux puces de capteur délivrent en sortie des valeurs positives pour un flux magnétique passant dans l'interstice respectivement, une direction d'induction magnétique de l'une des deux puces de capteur (32a, 32b) est opposée à la direction d'induction magnétique de l'autre des deux puces de capteur (32a, 32b).
